# EUROPEAN PATENT APPLICATION

(11) **EP 2 451 079 A1**
(43) Date of publication of application: **09.05.2012**
(21) Application number: 10189865.8
(22) Date of filing: 03.11.2010
(51) Int. Cl.: H03K 17/725, H03K 17/79, H03K 17/30

(54) **Soft start for AC power switching**

(71) Applicant: Vetco Gray Controls Limited, Bristol BS48 1BS (GB)
(72) Inventor: Bartelous, Peter, Beaminster, Dorset DT8 3LD (GB)
(74) Representative: Emerson, Peter James

(57) **Abstract**

An AC power switching module comprises: AC current input (V1) and output (V5) means; a thyristor (17) located between said input and output means for selectively blocking or passing said AC current, said thyristor having a gate input (V4) for activating said thyristor to cause said AC current to pass; and activation means for sending a pulsed activation signal (V4) to said gate input and thus activate said thyristor, said activation means being caused to send said activation signal upon receipt of an enabling command signal. The activation means comprises means for, upon receipt of an enabling command signal (14), gradually increasing the duty cycle of the activation signal until it reaches a steady value.
Said means are a zero crossing point detector (12), a sawtooth waveform generator (13), a ramp generator circuit (15) and a comparator (16).

## Description

The present invention relates to an AC power switching module and a method of switching AC current.

Underwater facilities, for example subsea well installations such as hydrocarbon production wells, are typically supplied with AC electrical power from the surface via an umbilical cable. Communications signals are often superimposed on the power feed, a system commonly known as a communication on power system or "COPS". At the well end, the umbilical typically terminates at an umbilical termination unit (UTA). From the UTA, power and communications signals may be fed to at least one subsea control module (SCM) which may be mounted on the well tree. The UTA may feed a number of wells within a well complex. SCMs are also sometimes required to supply electric power to subsea devices external to the tree. Switching of this AC electric power between the various well functions is regulated by a number of power switching modules (PSM), typically housed within a power distribution and protection module (PD&PM), which is in turn part of a subsea distribution unit. Each PSM is typically a thyristor, e.g. a silicon/semiconductor controlled rectifier (SCR)-based AC power static switch or TRIAC, as is known in the art. SCRs exhibit the property that if a gate-to-cathode voltage (a "trigger" voltage) or "activation signal" is applied to a gate input (also known as a "trigger" electrode) of the SCR which exceeds a certain threshold, the SCR is caused to activate to an "on" state in which it may conduct current. Once activated, an SCR will remain in this "on" state even after removal of the trigger voltage, so long as the current through the device remains above a so-called "holding" current. If the current through the SCR falls below the holding current for a certain period of time, the device will de-activate or "switch off", so that it no longer passes current therethrough. If the gate is pulsed but the current through the device remains below the holding current, the device will remain de-activated.

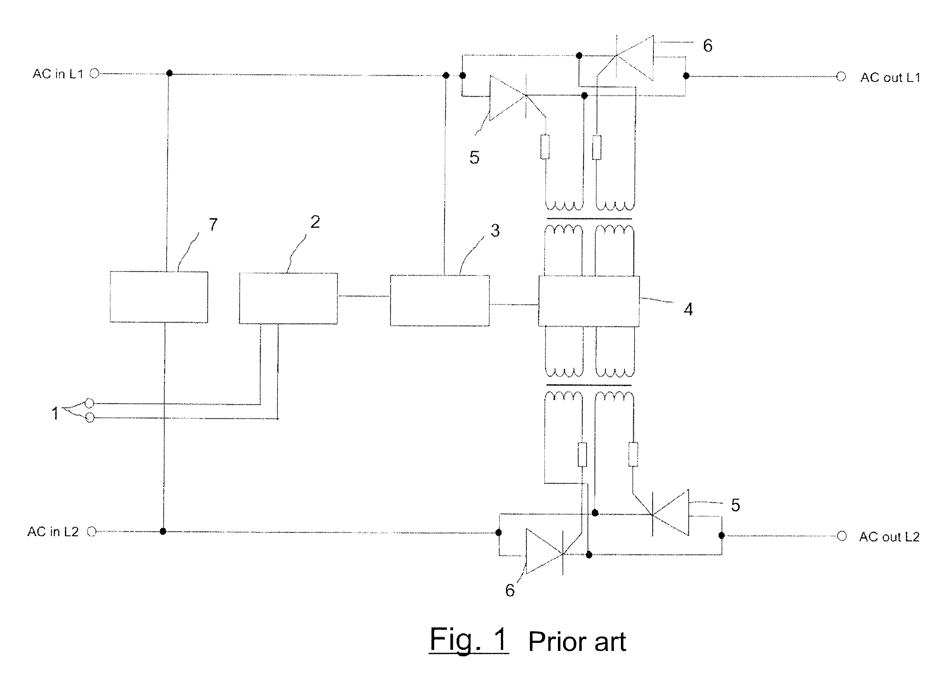

A known power switching module is schematically shown in Fig. 1. The AC power is supplied to rails L1 and L2, with input means on the left side of Fig. 1, and output means on the right side. In normal use, a control input 1 is provided to an opto-isolator 2. When the control input is received by opto-isolator 2, a high-low crossing detector 3 is enabled. The detector 3 is arranged to produce an output when the AC power voltage waveform crosses the zero voltage point. The output from detector 3 feeds and thus enables a pulse generator 4. When enabled, pulse generator 4 produces a continuous chain of pulses. The switching module shown has two similar switch units, one located on rail L1, and the other on rail L2. Each switch unit comprises two SCRs 5 and 6, which are connected in "inverse parallel" such that each SCR 5, 6 may effect blocking of one half-cycle of the AC waveform individually, such that in combination the entire waveform may be blocked. Outputs from pulse generator 4 are connected to the gate inputs of the SCRs 5 and 6, such that when generator 4 produces a chain of pulses, the SCRs 5 and 6 are activated or switched on, enabling the AC current to pass. The electronic circuitry shown in Fig. 1 is powered by low voltage power supply circuitry 7.

In use therefore, with the SCRs 5, 6 not conducting, the circuitry detects the zero voltage point of the AC waveform applied to the SCRs, and at that point enables pulses from the pulse generator 4 to be applied to the SCR gate inputs. Thus as the voltage waveform across the SCRs rises above zero volts, the SCRs conduct. The frequency of the trigger pulses is typically much greater than the frequency of the AC power waveform, and since the pulse train is continuously applied to the SCR triggers from the zero volts point onwards, continued triggering of the SCRs is ensured even if the current is below the minimum hold current of the device. Typically, switching modules apply the pulse train to the SCR gate inputs until a switch off of the power is required, whereupon the pulse train is removed from the SCR gate inputs by means of changing the control input 1. Since the current through the SCRs is AC, this will fall below the holding current within one cycle, causing deactivation of both SCRs, therefore blocking the AC current within a short time.

A problem with such switching modules is that the pulses applied to the SCR triggers can appear superimposed on the output AC power waveform. This may result in crosstalk noise to, and disruption of, the communications signals and system.

One way to overcome these problems would be to activate switching by applying a steady DC voltage to the gate inputs of the thyristors/SCRs of a power switching module to act as a trigger. With such a technique, the SCR triggering noise crosstalk into the communications signal would be minimised. Additionally, the SCRs are also more likely to switch at low holding current than using a pulsed trigger. Furthermore, problems associated with phase delay between voltage and current would also be negated.

Use of DC to trigger SCRs is known as such, examples being shown by EP-A1-0359675 (Merlin Gerin) and US4333048 (Bishop). However it should be noted that the use of DC triggering in respect of underwater facilities is not known to the Applicant's knowledge.

A further problem relates to the fact that with the present use of AC electrical power, an AC - DC power convertor must be provided at the underwater location, typically on the tree, since the components require DC. Generally therefore, a transformer is provided, feeding the AC to DC power converter, and both these components are typically located within a subsea electronics module (SEM), housed in a subsea control module (SCM) mounted on the well tree. However, it is well known that when power is suddenly applied to either or both of the transformer or the power converter, a high current surge may result. These high current surges have been especially observed in AC equipment that use toroidal transformers, and is caused by residual magnetism or polarisation of the transformer's core. When full power is applied, the transformer's core may saturate, causing a very high current spike to flow during the first half cycle of the AC power.

Furthermore, high current surges can also result from the initial charging of capacitors in the AC to DC power converters.

In both cases, such surges may cause problems, including potential damage to equipment and circuitry. Conventionally, underwater equipment includes a current limiting protection circuit, designed to protect the equipment/circuitry from high currents. Even if a surge created by the application of power to a transformer/capacitor is not of a sufficient level to damage equipment, it may still be high enough to trigger actuation ("tripping") of the current limiting protection circuit, in other words a false tripping is caused, which in itself is a problem, causing delays in production.

Current methods of overcoming these problems include:
a) the introduction of a delay to the current limiting protection circuit, thus overcoming the problem of false tripping of the current limit protection circuit;
b) amplitude control of the AC power using, for example, MOSFETS; or
c) use of a relay switched-in resistor.

In practice, none of these solutions is perfect. For example, adoption of a) will leave the AC power line to other equipment vulnerable to blackouts or "brown outs". Both b) and c) meanwhile have problems with heat dissipation, require bulky circuits and have to be tailored carefully to match the value of the load, which has to be known and fixed.

Furthermore, problems associated with such surges would also be present if a DC triggering system were used, such as those mentioned above.

It is an aim of the present invention to overcome these problems, i.e. to provide a power switching module with both reduced crosstalk and protection from surges.

In accordance with the present invention, this aim is achieved by using a "soft start" to apply an activation signal to the AC power switching modules of gradually increasing duty cycle, within a DC triggering system.

Such a soft start may be achieved by using ramped phase control of the AC power switching modules, which in turn gradually ramps up the AC power passed by the thyristor and thus applied to the transformer. In this way the transformer core is gently de-gaussed over a number of AC cycles, thus preventing the core from saturating and thereby eliminating a high current surge.

By "gradually", it is meant that the duty cycle of the activation signal increases over a plurality of AC cycles until it reaches a steady value.

In addition, the methodology of the present invention also reduces the high current surge that can result from the initial charging of capacitors in the AC to DC power converters that follow the transformer. By increasing the applied power gradually, the capacitor charging current is limited.

The present invention is defined by the accompanying claims.

More particularly, in accordance with a first aspect of the invention there is provided an AC power switching module comprising:
AC current input and output means;
a thyristor located between said input and output means for selectively blocking or passing said AC current, said thyristor having a gate input for activating said thyristor to cause said AC current to pass; and
activation means for sending a pulsed activation signal to said gate input and thus activate said thyristor, said activation means being caused to send said activation signal upon receipt of an enabling command signal wherein:
   the activation means comprises means for, upon receipt of an enabling command signal, gradually increasing the duty cycle of the activation signal until it reaches a steady value, for example a steady value which is a duty cycle of 100%.

Such a power switching module may be located in a subsea control module, an umbilical termination assembly associated with an underwater well facility.

In accordance with a second aspect of the invention there is provided a method of switching AC current, comprising the steps of:
providing a thyristor located between AC input and output means for selectively blocking or passing said AC current, said thyristor having a gate input for enabling activation of said thyristor to allow said AC current to pass; and
activating the thyristor by applying a pulsed activation signal to the gate input of gradually increasing duty cycle, until the latter reaches a steady value, for example a steady value which is a duty cycle of 100%.

The invention will now be described with reference to the accompanying figures, of which:
Fig. 1 schematically shows a conventional power switching module;
Fig. 2 schematically shows a power switching module in accordance with the present invention; and
Fig. 3 schematically shows an exemplary configuration of the drive circuitry used in the module shown in Fig. 2; and
Fig. 4 is a waveform diagram illustrating the soft start procedure in accordance with the present invention.

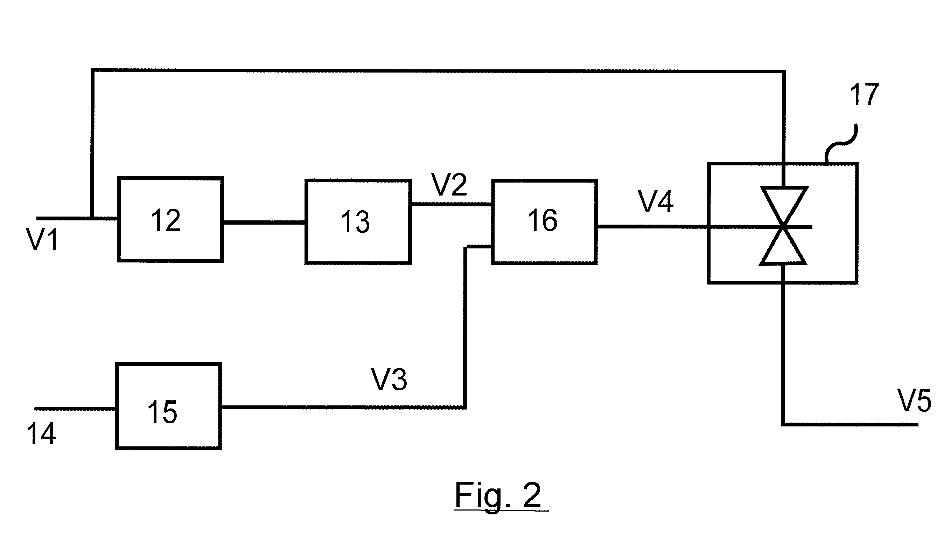

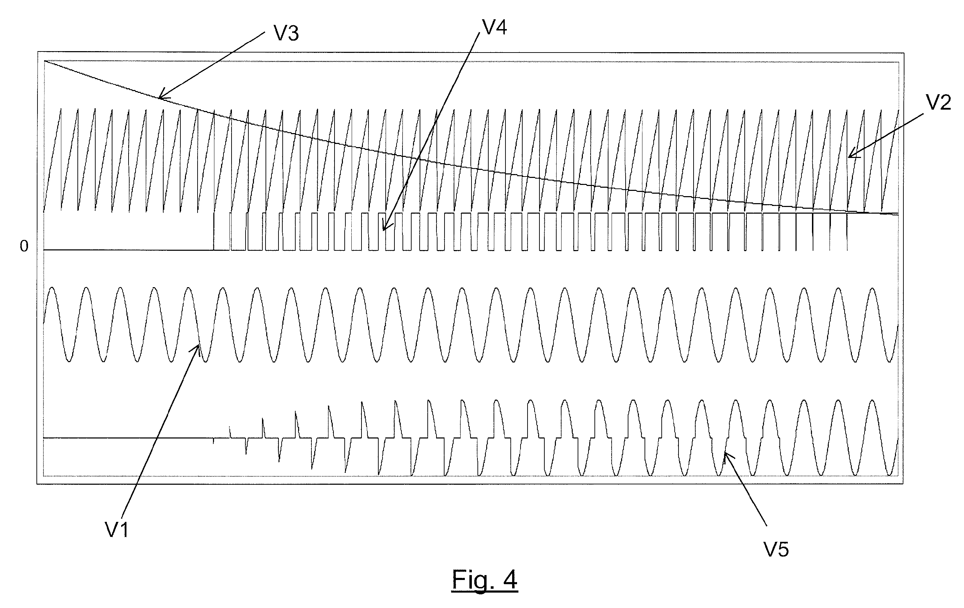

An exemplary AC power switching module in accordance with the present invention is schematically shown in Fig. 2, in conjunction with Fig. 4.

An input mains AC supply V1 is fed to a zero crossing point detector circuit 12. The output of the zero crossing detector circuit 12 connects to a reference waveform generator, in this case a sawtooth waveform generator 13. The output of sawtooth waveform generator 13, designated voltage V2, is of higher frequency than the mains AC waveform, as can be seen from Fig. 4. The sawtooth waveform generator 13 outputs V2 to a comparator 16. Comparator 16 outputs a voltage V4 to an AC power switching device 17, i.e. a thyristor, which is operable to pass or block the mains voltage V1. The output voltage passed by thyristor 17 is designated V5. In addition, an enabling command ("power-on") signal 14 from the well control system is fed to a ramp generating circuit 15. The output of the ramp generating circuit 15, designated V3, connects to the comparator 16, such that the comparator is operable to compare the inputs V3 and V2, i.e. the inputs from ramp generating circuit 15 and sawtooth waveform generator 13, with its output voltage V4 being dependent on the comparison result.

Referring also to timing diagram Fig. 4, in use, when the AC mains input V1 crosses zero volts, the zero-crossing detector circuit 12 outputs a trigger into the sawtooth waveform generator 13, resetting V2 to zero. In other words, the sawtooth waveform V2 is caused to be phase-synchronised to the mains input V1. As mentioned above, the enabling command signal 14 is fed to the ramp generating circuit 15, whereby when the signal 14 is set to ON, the initial output voltage V3 is caused to ramp down to zero. The time duration for this ramping is chosen to suit the required soft start-up time duration, typically a second for example. The sawtooth waveform V2 and the ramp waveform V3 are compared by comparator 16, which produces output waveform V4. As can be seen from Fig. 4, the output waveform V4 switches rapidly between a zero volts baseline amplitude and a maximum amplitude Vₘₐₓ, with the fall from Vₘₐₓ to zero coinciding with the amplitude drop of sawtooth waveform V2. Additionally, the length of the Vₘₐₓ peaks is dependent on the amplitude of ramp waveform V3, such that as V3 falls, the peak length increases. This means that as V3 falls, the duty cycle of V4 increases from 0% to 100%.

The output waveform V4 constitutes an activation signal, and is fed to the triggers of thyristor 17. This device is operable to only pass current when the trigger input is greater than a set voltage, this set voltage being less than Vₘₐₓ. Therefore, application of activation signal waveform V4 to the gate input of thyristor 17 causes a ramping up of the duration of the phase of the output voltage V5 and therefore increasing AC power passed by the thyristor.

When the power enable signal 14 is set to OFF, V3 restores to maximum voltage. This causes waveform V4 to return to zero volts, and thus the thyristor 17 switches off.

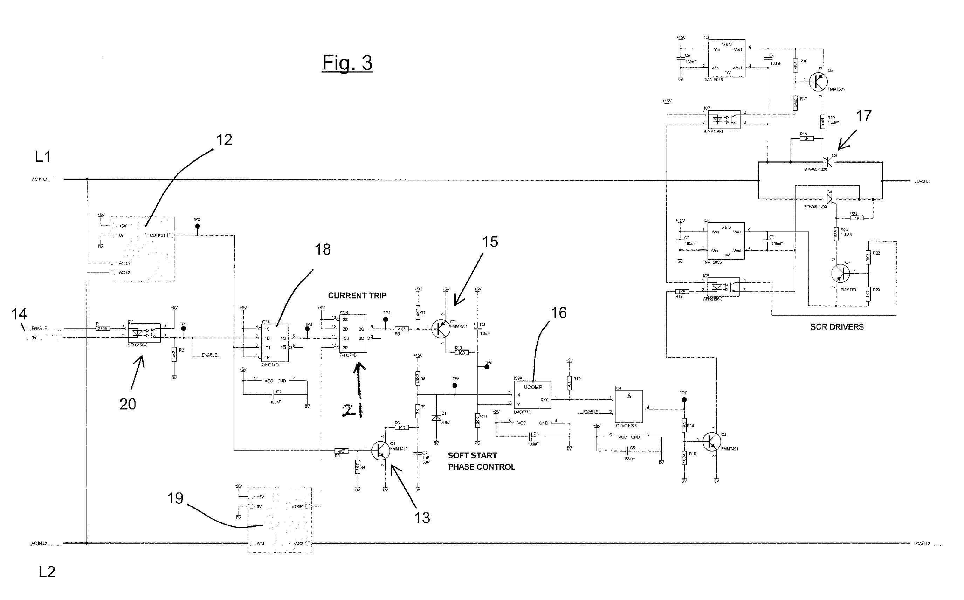

Fig. 3 schematically shows an exemplary configuration of the drive circuitry used in the module shown in Fig. 2. As with the conventional power switching module shown in Fig. 1, AC power is supplied to rails L1 and L2. A DC power supply unit (not shown) is connected between L1 and L2, for providing power (Vd) to the various electronic components of the module. Suitable power supplies are already provided with known subsea systems, and so substantial modifications are not required when using such power supplies. For example, such a power supply may commonly provide 12 V DC as Vs. In this way, and as further described below, the power supply unit provides a DC power source for the trigger voltage for thyristors 17.

The enabling command signal 14 is connected, via an opto-isolator 20 with load resistances on each side as required, to the D-input of a D-type flip-flop 18. This isolation provides a safe low-voltage interface to the remainder of the circuit, which may reside at a relatively high AC potential. The input 14 receives control signals from an external source, for example from a human or computer controller which may be located topside (at the surface) for example, or from an automatic safety system arranged to provide automatic switch-off for example. Monitoring means in the form of the zero-voltage crossing detector 12 connected across rails L1, L2 detects when the AC power voltage waveform of these rails is at a predetermined point in its cycle, in this case where the zero voltage point is crossed, and produces an output when this occurs. The output from detector 12 is connected to the clock-input of the D-type flip-flop 18. Zero-voltage crossing detector 12 is shown as a composite component, such detectors being well known in the art.

The Q-output from flip-flop 18 is passed to a current trip section 21, namely the flip-flop IC28, which is fed by an overcurrent trip level detector 19 connected to rail L2. The output from the current trip section is connected to ramp generating circuit 15.

The zero crossing voltage detector 12 also outputs to sawtooth waveform generator 13, which means that the waveform generator 13 and ramp generating circuit 15 are synchronised.

Outputs from the sawtooth waveform generator 13 and ramp generating circuit 15 are passed to comparator 16 as described above. The comparator 16 outputs to the thyristor drive circuits. For simplicity, Fig. 3 only shows one such drive circuit, i.e. only one thyristor pair 17 connected in anti-parallel is shown, however generally the output from comparator 16 would be sent to four separate drive circuits, which drive respective thyristor pairs. These are arranged in a similar manner as in Fig. 1, i.e. connected in inverse parallel, in series with rails L1 and L2, such that each individual thyristor of the pair may effect blocking of one half-cycle of the AC waveform individually, such that in combination the entire waveform may be blocked. Outputs from the SCR drive circuits are connected to the gate inputs of thyristors 17.

It can be seen that with this arrangement, the flip-flop 18 is able to control all of the thyristors 17. Since, after the initial soft-start period, V4 is constant, it follows that, unlike the prior art arrangement shown in Fig. 1, the thyristors 17 are driven by DC.

As is well-known and standard, the AC waveform on rails L1 and L2 is substantially sinusoidal. This waveform is monitored by the zero-voltage crossing detector 12 which has the property of "squaring" the waveform as described above. In other words, although a continuous sinusoidal waveform is monitored, the detector 12 effectively outputs a square wave form, the amplitude of which alternates regularly between Vd and Vs. This output signal from detector 12 provides the clock input for D-type flip-flop 18.

The D-input to flip-flop 18 is provided by the enabling control signal input 14, which is a simple on/off or high/low signal. In normal use, i.e. during satisfactory operation with no need for switch-off of the AC power, the enabling control signal is set to "on"/high. When AC-power switch off is required, the enabling control signal is removed from input 14, and thus also from the D-input of flip-flop 18.

As is well-known in the art, a D-type flip-flop has the properties that the Q output always takes the state of the D input at the moment of a positive clock edge. In the present case, this means that the Q output of flip-flop 18 will take the state of the D input when the output from zero-voltage crossing detector 12 goes high (+x), indicating that the zero-voltage point of the AC cycle has been crossed, with the voltage rising. At this point the Q output (assuming that the enabling control 14, forming the D input, is "on/high") will also go high, and it will remain high from then on. It should be noted that since the state of the flip-flop 18 only updates on the positive clock edge, when the AC power cycle falls, again crossing zero voltage, the Q output will be unaffected. This means that in normal, enabled condition, once clocked the Q output will remain constant and high.

If the enabling control input signal is removed or turned "off"/low, then the Q output will likewise go low at the following positive clock edge.

The Q output signal from flip-flop 18 controls each thyristor drive circuit. When an "on" / high Q signal is received by opto-isolator 14, DC current flow is enabled. This current flow provides a steady DC trigger voltage to the gate input of thyristor 17. This causes thyristor 17 to activate to an "on" state in which it conducts current, i.e. the AC waveform. The thyristor 17 will remain in this "on" state while the AC current passing therethrough exceeds the holding current. When the AC current falls below the holding current, then the thyristor 17 tends to act rather like a transistor rather than a latch, and will be forced on as long as the trigger voltage to the SCR is maintained (n.b. if of course the trigger voltage is removed and the AC current is below the holding current, then the thyristor 17 will turn "off", and this will occur at the most within a half-period of the AC waveform). When the AC waveform subsequently rises to exceed the holding current, the thyristor 17 will activate immediately since a trigger voltage is applied constantly. Importantly, since the trigger voltage is steady and not pulsed as in prior art systems, there will be no associated spiking affecting the AC passing through the thyristor 17. If the enabling control input signal is removed from the D-input of flip-flop 18, such that the Q goes low at the subsequent positive clock edge, the DC trigger voltage will be stopped. In this case, the thyristors will not be activated when the AC waveform rises above the holding current, but will remain de-activated until after the enabling control signal input is restored.

The other drive circuits (not shown), which drive respective thyristors operate in a similar manner. Since they are all driven by the same Q output from flip-flop 18, they will all cause activation of their respective thyristors at substantially the same moment.

It can be seen therefore that when an enabling control input signal is applied via input 14, the module will act to activate the thyristors with a soft start period as described above. Once this soft start is over, the thyristors will be activated by DC and thus permit current to pass therethrough which is substantially free from noise associated with prior-art pulsed switching systems and with noise associated with supply currents, so that there is minimal crossover distortion. The thyristors will remain activated until the respective current therethrough falls to below the holding current, and so all thyristors will de-activate at the most within a half-period of the AC waveform.

If the enabling control signal input is removed from the D-input of flip-flop 18, the Q-output will go low at the subsequent positive clock edge, causing the cessation of the DC trigger voltage to all thyristors. In this case, the thyristors will not be activated when the AC waveform rises above the holding current, but will remain de-activated until after the enabling control signal input is restored.

Crossover distortion will be minimal with the above-described DC drive and provide a better environment for Communications on Power systems. This idea will also work well for high power factors where the current and voltage are out of phase since the drive will always be ON to the SCR during the entire mains cycle.

The above-described embodiment is exemplary only, and various alternatives and modifications within the scope of the invention will be apparent to those skilled in the art.

For example, zero-voltage crossing detectors may take a variety of forms, for example it is envisaged to use a detector including a comparator, such that the input voltage may be measured.

It will be appreciated that the thyristors could comprise SCRs or TRIACS (triodes for alternating current), the TRIAC also being classed as a type of thyristor.

Although the reference waveform generator described above is a sawtooth waveform generator, this is not essential, and over waveforms may be used.

## Claims

1. An AC power switching module comprising:
AC current input and output means;
a thyristor located between said input and output means for selectively blocking or passing said AC current, said thyristor having a gate input for activating said thyristor to cause said AC current to pass; and
activation means for sending a pulsed activation signal to said gate input and thus activate said thyristor, said activation means being caused to send said activation signal upon receipt of an enabling command signal, wherein
the activation means comprises means for, upon receipt of an enabling command signal, gradually increasing the duty cycle of the activation signal until it reaches a steady value.

2. A module according to claim 1, wherein said steady value is a duty cycle of 100%.

3. A module according to claim 1 or 2, wherein the activation means comprises a ramp generating circuit operable to produce a ramped waveform of gradually reducing power upon receipt of the enabling command signal.

4. A module according to claim 3, wherein the activation means comprises means for setting the duty cycle of the activation signal in dependence of the ramped waveform power.

5. A module according to claim 4, wherein the activation means comprises a comparator for producing the activation signal with a duty cycle in dependence of the ramped waveform power compared to a reference waveform power.

6. A module according to claim 5, wherein the activation means comprises a sawtooth waveform generator for generating the reference waveform.

7. A module according to either of claims 4 and 5, wherein the reference waveform is synchronised to the AC current.

8. A module according to claim 7, wherein the activation means comprises a zero-voltage crossing detector for detecting when the AC current passes zero, and triggering the reference waveform at that point.

9. A subsea control module comprising the power switching module according to any preceding claim.

10. An umbilical termination assembly comprising a module according to any of claims 1 to 8.

11. An underwater well facility comprising a module according to any of claims 1 to 9.

12. A method of switching AC current, comprising the steps of:
providing a thyristor located between AC input and output means for selectively blocking or passing said AC current, said thyristor having a gate input for enabling activation of said thyristor to allow said AC current to pass; and
activating the thyristor by applying a pulsed activation signal to the gate input of gradually increasing duty cycle, until the latter reaches a steady value.

13. A method according to claim 12, wherein said steady value comprises a duty cycle of 100%.

14. A method according to claim 12 or 13, comprising the steps of producing a ramped waveform of gradually reducing power upon receipt of an enabling command signal and setting the duty cycle of the activation signal in dependence on the ramped waveform power.

15. A method according to claim 14, comprising the step of producing the activation signal with a duty cycle in dependence of the ramped waveform power compared to a reference waveform power.

16. A method according to claim 15, comprising the step of synchronising the reference waveform to the AC current.

17. A method according to claim 16, comprising the step of detecting when the AC current passes zero, and triggering the reference waveform at that point.
